# EUROPEAN PATENT APPLICATION

(11) **EP 4 835 579 A1**
(43) Date of publication of application: **04.11.2026**
(21) Application number: 25173656.7
(22) Date of filing: 30.04.2025
(51) Int. Cl.: G03F 7/20, H01L 21/66

(54) **SUBSTRATE BACKSIDE ACTUATION PROCESS WITH FEED-BACK AND FEED-FORWARD MECHANISM**

(71) Applicant: ASML Netherlands B.V., 5500 AH Veldhoven (NL)
(72) Inventor: MOS, Everhardus, Cornelis, 5500 AH Veldhoven (NL); VAN HAREN, Richard, Johannes, Franciscus, 5500 AH Veldhoven (NL); VAN DIJK, Leon, Paul, 5500 AH Veldhoven (NL)
(74) Representative: ASML Netherlands B.V.

(57) **Abstract**

There is provided a method of determining a backside process correction for a deformation of a substrate, the method comprising: obtaining feed-forward parameter of interest error data of the substrate; obtaining feed-back parameter of interest error data of a previously processed substrate; obtaining at least one model configured to map the feed-forward parameter of interest error data to a backside process correction configured to correct for an expected deformation of the substrate; and determining the backside process correction to be applied to the substrate to correct for the expected substrate deformation using the at least one model, the feed-forward parameter of interest error data and the feed-back parameter of interest error data.

## Description

### FIELD

The present invention relates to methods and apparatus for applying patterns to substrates, and in particular to a method of processing semiconductor substrates in a lithographic manufacturing process.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In order to monitor the lithographic process, parameters of the patterned substrate are measured. Parameters may include, for example, the overlay error between successive layers formed in or on the patterned substrate and critical linewidth (CD) of developed photosensitive resist. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured. Two main types of scatterometer are known. Spectroscopic scatterometers direct a broadband radiation beam onto the substrate and measure the spectrum (intensity as a function of wavelength) of the radiation scattered into a particular narrow angular range. Angularly resolved scatterometers use a monochromatic radiation beam and measure the intensity of the scattered radiation as a function of angle.

Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

Process control methods are used in the manufacture of integrated devices to monitor and control the processes of application of a pattern on a substrate or measurement of such a pattern. Such process control techniques are typically performed to obtain corrections for control of the process. Subsequently, it is sometimes required (for certain devices) to bond substrates together. Bonding processes include die-to-die, die-to-wafer and wafer-to-wafer. Wafer-to-wafer bonding, where whole wafers are permanently bonded together prior to dicing, has the potential of providing a high accuracy and high throughput bonding solution.

It would be desirable to improve process control methods in the manufacture of integrated devices.

### SUMMARY OF THE INVENTION

In an aspect, there is provided a method of determining a backside process correction for a deformation of a substrate, the method comprising: obtaining feed-forward parameter of interest error data of the substrate; obtaining feed-back parameter of interest error data of a previously processed substrate; obtaining at least one model configured to map the feed-forward parameter of interest error data to a backside process correction configured to correct for an expected deformation of the substrate; and determining the backside process correction to be applied to the substrate to correct for the expected substrate deformation using the at least one model, the feed-forward parameter of interest error data and the feed-back parameter of interest error data.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example, with reference to the accompanying drawings in which:
- Figure 1 depicts a lithographic apparatus together with other apparatuses forming a production facility for semiconductor devices;
- Figure 2 comprises a schematic diagram of a scatterometer for use in measuring targets;
- Figure 3 is a flow diagram describing a present method of manufacturing integrated devices which utilizes substrate bonding;
- Figure 4 depicts a known substrate backside processing method.
- Figure 5 depicts a substrate backside processing method in accordance with some embodiments.
- Figure 6A depicts a substrate backside processing method in accordance with some embodiments.
- Figure 6B depicts a substrate backside processing method in accordance with some embodiments.

### DETAILED DESCRIPTION OF THE INVENTION

Before describing embodiments of the invention in detail, it is instructive to present an example environment in which embodiments of the present invention may be implemented.

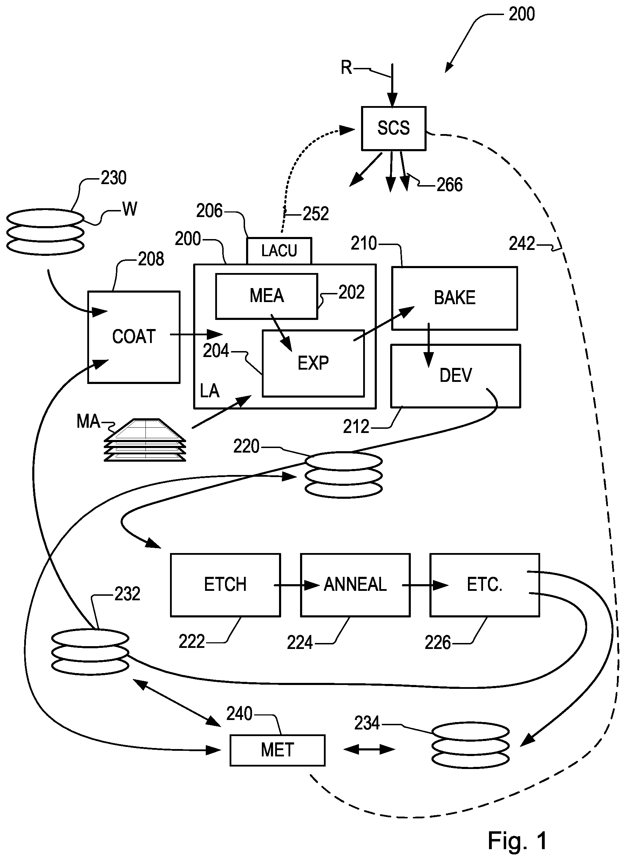

Figure 1 at 200 shows a lithographic apparatus LA as part of an industrial production facility implementing a high-volume, lithographic manufacturing process. In the present example, the manufacturing process is adapted for the manufacture of semiconductor products (integrated circuits) on substrates such as semiconductor wafers. The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore, some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly, a manufacturing facility in which litho cell LC is located also includes a metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

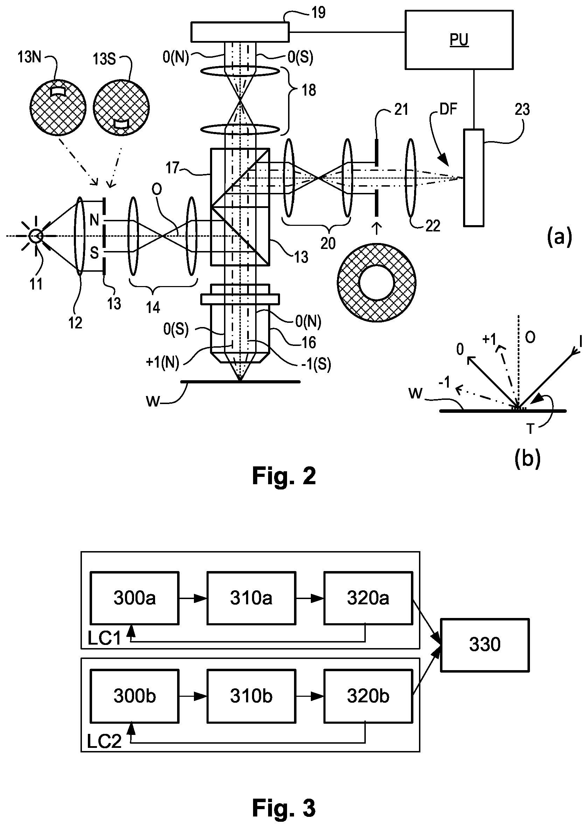

A metrology apparatus suitable for use in embodiments of the invention is shown in Figure 2(a). A target T and diffracted rays of measurement radiation used to illuminate the target are illustrated in more detail in Figure 2(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 2(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figures 2(a) and 2(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 2(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for many measurement purposes such as reconstruction used in methods described herein. The pupil plane image can also be used for focusing the metrology apparatus and/or normalizing intensity measurements of the first order beam.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 2 are purely examples. In another embodiment of the invention, on-axis illumination of the targets is used and an aperture stop with an off-axis aperture is used to pass substantially only one first order of diffracted light to the sensor. In yet other embodiments, 2^{nd}, 3^{rd} and higher order beams (not shown in Figure 2) can be used in measurements, instead of or in addition to the first order beams.

The target T may comprise a number of gratings, which may have differently biased overlay offsets in order to facilitate measurement of overlay between the layers in which the different parts of the composite gratings are formed. The gratings may also differ in their orientation, so as to diffract incoming radiation in X and Y directions. In one example, a target may comprise two X-direction gratings with biased overlay offsets +d and -d, and Y-direction gratings with biased overlay offsets +d and -d. Separate images of these gratings can be identified in the image captured by sensor 23. Once the separate images of the gratings have been identified, the intensities of those individual images can be measured, e.g., by averaging or summing selected pixel intensity values within the identified areas. Intensities and/or other properties of the images can be compared with one another. These results can be combined to measure different parameters of the lithographic process.

Figure 3 shows a device manufacturing arrangement for making bonded substrates (and therefore ICs based on bonded substrates) comprising a first manufacturing lithocell LC1 and a second manufacturing lithocell LC2. Within each lithocell is a pair of lithographic processing systems 300a, 300b and first metrology systems 310a, 310b. The lithographic processing system 300a, 300b, may comprise a full patterning system. Such a system may comprise, for example, an optical lithographic apparatus or scanner such as described in respect of Figure 1, a track tool, a deposition tool, an etch tool, any other apparatus used in the patterning process, or any combination selected therefrom. The systems may also each comprise a software application 320a, 320b in communication with its respective lithographic processing system 300a, 300b and metrology system 310a, 310b, so that results, designs, data, etc. of the lithographic processing system 300a, 300b and/or the metrology apparatus 310a, 310b may be stored and analyzed by the software application 320a, 320b at the same time or different times.

Once pairs of substrates or wafers are completed from each of lithocell LC1 and lithocell LC2, they may be bonded within a bonding tool 330 to obtain a bonded wafer. Bonding in this context is wafer-to-wafer bonding where whole wafers are aligned and bonded together such that individual dies on each wafer are aligned. The concept of wafer-to-wafer bonding is known and used in many IC manufacturing processes. The bonding tool 330 may comprise a bonding alignment device for aligning the wafers together for bonding. For example, the bonding tool 330 may perform pre-align using box-in-box marks provided to wafers (e.g., one box on each wafer), with visual inspection of marks used for alignment quality/ position control. Another method uses two imaging sensors (e.g., face to face) which are first calibrated together to find their relative positions; each sensor is then used to separately align a respective wafer to be bonded.

Lithocell LC1 and lithocell LC2 may be the same lithocell, different lithocells but comprising one or more shared tools and elements, or be completely different lithocells having completely different sets of apparatuses and tools, possibly even at different sites or fabs. For example, one or more of the tools or apparatuses of the lithographic processing systems 300a and 300b may comprise different tools or the same tools within each respective system. Similarly, metrology apparatuses 310 and 310b may be the same apparatus or different apparatuses. The software application 320a, 320b may be comprised within one or both of the respective lithographic processing systems 300a, 300b and/or one or both of the first metrology systems 310a, 310b, or elsewhere.

Once bonded, the bonded wafer may be subject to further lithographic patterning and processing (such as grinding). As such, alignment will be performed on the bonded wafer; e.g., for aligning the substrate and determining feed-forward corrections based on measured grid deformities. Also, post-exposure metrology, such as overlay metrology, may be performed on the bonded wafer after exposure; e.g., to determine feed-back corrections for subsequent wafers.

Wafer-to-wafer and die-to-wafer (or substrate-to-substrate) bonding have gained increased attention owing to the possibilities it brings to enable advancements in the semiconductor industry. A typical wafer-to-wafer and/or die to wafer bonding process may comprise joining (i.e., bonding) two substrates to one another, and in some cases applying physical pressure, temperature and/or an electric field to facilitate bonding. In some cases, bonding may be facilitated by the chemical properties of the surfaces of the substrates to be bonded (e.g., click chemistry).

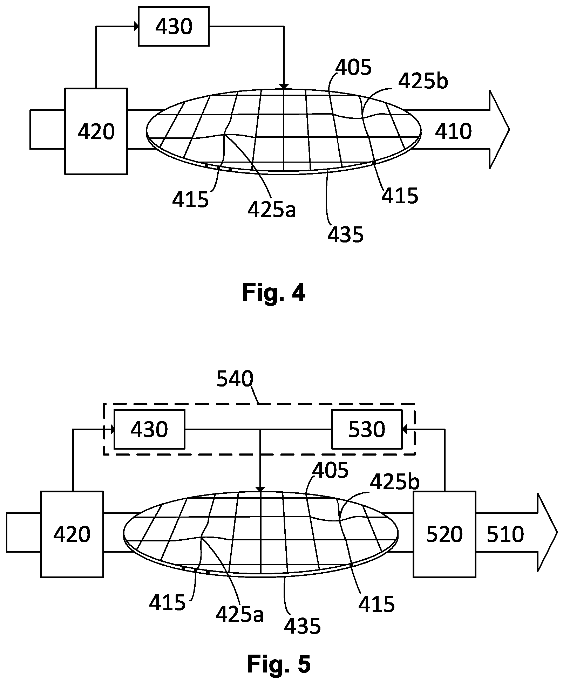

With reference to Figure 4, during wafer processing, substrates (e.g., substrate 405) may become physically distorted (such as an in-plane deformation), e.g., owing to residual stress from layers on the substrate, etching processing steps and/or polishing steps and the like. Such substrate deformations may be represented by deviation from a 2-dimensional grid superimposed on the wafer surface representing ideal surface flatness, such as deviations, or distortions, shown in regions 425a and 425b of substrate 405 in Figure 4. Such distortions are a source of overlay issues, either between consecutive layers on a substrate, or between a donor and/or acceptor substrate during die to wafer or wafer to wafer bonding processes.

For grid deformation use cases, it is known to configure a scanner to follow a deformed grid when patterning to mitigate the effect of said deformations. This method may become problematic, e.g., if an actuation potential is reduced in a layer subsequent to the layer where the grid deformation is introduced, or where two pattered substrates need to be bonded together within a limited overlay tolerance.

Scanner configuration, or so-called lithography actuation, or litho-actuation on a previous layer may be used to pre-compensate grid distortion resulting in a "straighter" grid (i.e., closer to the ideal grid) after processing. A drawback of this is that there is a substantial delay time between layers, and only relatively slow variations in the wafer grid can be corrected. A first substrate is required as a "send ahead" substrate through the current process flow to determine initial corrections. Furthermore, there are logistical challenges associated with the known methods: substrates are prepared for a process step and/or tool for future processing. If the process and/or tool is not available at the predetermined later future time (or for example a tool has been reset), then the performance of those substrate will be negatively impacted.

With further reference to Figure 4, another known method of correcting for an absolute wafer shape and/or grid deformation is wafer backside processing (also referred to herein as backside actuation or more generally a backside process correction). A typical wafer backside processing flow 410 comprises depositing a layer 435 onto the backside of a substrate (e.g., substrate 405) to induce stress across the substrate. The backside layer is then patterned (e.g., with pattern 415) to change the stress as a function of the location on the wafer. Patterning may be achieved by etching, ion implantation or other typical masking and patterning processes available. The wafer backside processing method uses computational modelling 430 based on feed-forward parameter of interest error data 420 (e.g., data related to an error in a parameter of interest such as wafer alignment, wafer shape and/or overlay data, which is used in a feed-forward loop, i.e., prior to the backside process correction) to calculate the properties (e.g., material properties, thickness) of the backside layer 435 and determine the pattern 415 to be applied. Said computational modelling may comprise predictive modelling and/or physics based modelling.

Thus, the typical wafer backside processing method is a so-called feed-forward method, relying on measurements prior to applying deformation corrections in order to determine parameters of said correction. Alignment and/or wafer shape measurements may reference an "ideal" wafer flatness e.g., with respect to a scanner reference (i.e., measurement components of a scanner system) or so called gold standard wafer. Any inaccuracies in the computational model or input set-point of the requested grid distortion to be corrected will result in residual grid deformation. Thus, there is a desire for improved methods of correcting an absolute substrate shape and/or grid deformation, for example to reduce said residuals.

With reference to Figure 5, aspects of the present disclosure provide for such an improved method of determining a correction for a substrate deformation, for example as induced by a process of semiconductor substrate manufacturing (e.g., substrate bonding, etching, chemical mechanical polishing and/or the like).

Still referencing Figure 5, in contrast to the typical backside actuation process, which is based on a data feed-forward mechanism, the presently proposed method further comprises a feed-back mechanism (i.e., via feed-back parameter of interest error data 520 of a previously processed substrate as described below) to determine a closed-loop correction that serves to tolerate inaccuracies in the feed-forward model.

Thus, in a first aspect, a method of determining a backside process correction for a substrate comprises obtaining feed-forward parameter of interest error data 420 of the substrate. Said feed-forward parameter of interest data may comprise data related to an error in a parameter of interest such as wafer alignment, wafer shape and/or overlay data.

The method further comprises obtaining feed-back parameter of interest error data 520 (i.e., parameter of interest error data (e.g., metrology data) that is used as part of a feed-back loop, determined post-backside process correction) of a previously processed substrate. Said previously processed substrate has been provided with backside process correction, e.g., a layer on its backside having a known pattern applied to it. The feed-back parameter of interest data of the previously processed substrate may comprise any of wafer shape, wafer grid, and/or overlay data. In this way, parameter of interest error data related to residual deformation (i.e., residual deformation not corrected by the backside processing) in the processed substrate may be determined.

The method further comprises obtaining at least one model 430 530 configured to map the feed-forward parameter of interest error data 420 to a backside process correction configured to correct for an expected deformation of the substrate. Similar to the known method of backside actuation, this step may comprise, for example, determining feed-forward parameter of interest error data 420 (e.g., data related to an error in a parameter of interest such as wafer alignment, wafer shape and/or overlay) to calculate the properties of a backside layer 435 and determine a pattern 415 to be applied in order to correct for said expected deformation of the substrate. That is, said model 430 may be obtained based on feed-forward parameter of interest error data 420.

**In** some examples, model 430 may comprise a neural network that has been trained on training data determined from test substrates, wherein the effects that different backside patterns have on the excitation of a substrate are observed.

Figure 5 shows at least one model 430 530 within context thread 540 along substrate process flow 510. In some examples, the at least one model comprises a first model 430 for mapping the feed-forward parameter of interest data to the backside process correction and a second model 530 for mapping the feed-back parameter of interest error data to the backside process correction.

The previously processed substrate may have been processed according to a process of semiconductor substrate manufacturing associated with the expected substrate deformation (e.g., substrate deformations 425a 425b), such as etching, substrate bonding and/or polishing and the like. That is, performing said process step on a substrate may lead to the expected substrate deformation.

When the feed-forward or feed-back parameter of interest data 420 520 comprises wafer shape and/or wafer grid data, scanner data may be used as an absolute grid reference (i.e., a so-called "gold standard" reference for wafer flatness).

The method further comprises determining the backside process correction to be applied to the substrate to correct for the expected substrate deformation using the at least one model, the feed-forward parameter of interest error data and the feed-back parameter of interest error data.

A previously processed substrate having been subject to backside process correction and at least one process step (e.g., etching, substrate bonding, polishing, before and/or after said backside process correction) may have residual deformation that has not been corrected by said backside process correction.

Thus, the determined backside process correction that is to be applied to the substrate to correct for the expected deformation according to the present disclosure also comprises a correction for residuals, as enabled by feed-back from measurements of the previously processed substrate. Advantageously, any residual errors may be corrected for using the proposed closed-loop system.

In some examples, the step of determining the backside process correction further comprises configuring the at least one model based on the feed-back information and determining the backside process correction using the configured model.

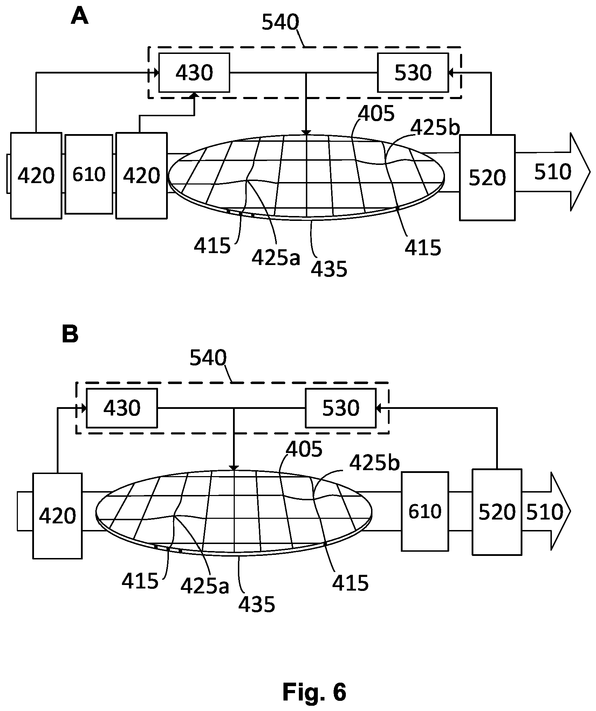

With reference to Figure 6A and 6B, in some examples a process step 610 may be included in process flow 510 before (as shown in Figure 6A) and/or after (as shown in Figure 6B) the determination of the backside process correction to be applied to the backside 435 of the substrate 405. In this way, for example, wafer grid distortion (e.g., as shown in regions 425a and 425b of substrate 405) may be corrected prior to a processing step 610 (e.g., substrate flattening in preparation for a substrate bonding process) and/or corrected for distortions induced by said processing step 610 (e.g., correcting for a binding distortion fingerprint post-substrate bonding).

In some example, processing step 610 may be any of substrate bonding, substrate thinning, substrate polishing (for example chemical mechanical polishing (CMP)), and/or substrate etching.

In some examples, as shown in Figure 6A, it may be advantageous to perform feed-forward measurements (i.e., of feed-forward parameter of interest data 420) before and after processing step 610, wherein the model is obtained based on first feed-forward parameter of interest error data (i.e., prior to the processing step) and second feed-forward parameter of interest data (i.e., post-processing step).

In some examples, for example when substrate bonding, it may be possible to use a bonding tool to correct for overlay errors at least partially resulting from wafer grid distortions. For example, a bonding tool may be enabled to correct for translational (Tx) and rotational (Rx) overlay errors by moving substrates relative to one another. In this case, the correctable part of the wafer grid distortion may be omitted by the proposed closed loop system. That is, the proposed closed loop system may be configured to only correct for model residuals (i.e., of model 430), rather than a correctable part of the wafer grid distortions.

Accordingly, the determined pattern may be applied to the substrate, thus providing for an improved correction method for substrates comprising a distorted wafer grid.

Further embodiments of the invention are disclosed in the list of numbered clauses below:
1. A method of determining a backside process correction for a deformation of a substrate, the method comprising: obtaining feed-forward parameter of interest error data of the substrate; obtaining feed-back parameter of interest error data of a previously processed substrate; obtaining at least one model configured to map the feed-forward parameter of interest error data to a backside process correction configured to correct for an expected deformation of the substrate; and determining the backside process correction to be applied to the substrate to correct for the expected substrate deformation using the at least one model, the feed-forward parameter of interest error data and the feed-back parameter of interest error data.
2. The method of clause 1, wherein the at least one model comprises a first model for mapping the feed-forward parameter of interest data to the backside process correction and a second model for mapping the feed-back parameter of interest error data to the backside process correction.
3. The method of clause 1 or clause 2, wherein the step of determining the backside process correction further comprises configuring the at least one model based on the feed-back parameter of interest error data and determining the backside process correction using the configured model.
4. The method of any previous clause, wherein the at least one model is obtained based on feed-forward parameter of interest error data and/or the expected deformation of the substrate.
5. The method of any previous clause, wherein the expected deformation of the substrate is an in-plane deformation of the substrate.
6. The method of any previous clause, wherein the feed-forward parameter of interest error data comprises pre-backside process correction metrology data of the substrate.
7. The method of any previous clause, wherein the feed-back parameter of interest error data comprises post-backside process correction metrology data of the previously processed substrate.
8. The method of any previous clause, wherein the feed-forward parameter of interest error data comprises data related to a substrate shape error, a substrate alignment error or an overlay error associated with the substrate.
9. The method of any previous clause, wherein the feed-back parameter of interest error data comprises data related to a substrate shape error, a substrate alignment error or an overlay error associated with the previously processed substrate.
10. The method of any previous clause, wherein the backside process correction comprises applying a layer to the backside of the substrate and applying a pattern to the layer.
11. The method of clause 10, wherein the pattern is applied by etching or ion implantation.
12. The method of any of clause 10 or clause 11, wherein the layer comprises silicon.
13. The method of any previous clause, wherein the previously processed substrate has been processed according to a process step, wherein the expected deformation of the substrate is associated with said process step.
14. The method of clause 13 further comprising: obtaining first feed-forward parameter of interest error data; performing the process step on the substrate; obtaining second feed-forward parameter of interest error data; and obtaining the model based on the first feed-forward parameter of interest error data and the second feed-forward parameter of interest error data.
15. The method of any of clauses 13 or 14, wherein the process step comprises any of etching, substrate bonding or polishing.
16. The method of any previous clause, further comprising applying the determined backside process correction to the substrate.
17. A computer program comprising program instructions operable to perform the method according to any of clauses 1 to 16 when run on a suitable apparatus.
18. A non-transient computer program carrier comprising the computer program of clause 17.
19. A processing apparatus comprising :at least one processor; and the non-transient computer program carrier of clause 18.
20. A substrate manufactured according to the method of any of clauses 1 to 16.
21. The substrate of clause 20 wherein the substrate is a bonded substrate.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultraviolet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method of determining a backside process correction for a deformation of a substrate, the method comprising:
obtaining feed-forward parameter of interest error data of the substrate;
obtaining feed-back parameter of interest error data of a previously processed substrate;
obtaining at least one model configured to map the feed-forward parameter of interest error data to a backside process correction configured to correct for an expected deformation of the substrate; and
determining the backside process correction to be applied to the substrate to correct for the expected substrate deformation using the at least one model, the feed-forward parameter of interest error data and the feed-back parameter of interest error data.

2. The method of claim 1, wherein the at least one model comprises a first model for mapping the feed-forward parameter of interest data to the backside process correction and a second model for mapping the feed-back parameter of interest error data to the backside process correction.

3. The method of claim 1, wherein the step of determining the backside process correction further comprises configuring the at least one model based on the feed-back parameter of interest error data and determining the backside process correction using the configured model.

4. The method of claim 1, wherein the at least one model is obtained based on feed-forward parameter of interest error data and/or the expected deformation of the substrate.

5. The method of claim 1, wherein the expected deformation of the substrate is an in-plane deformation of the substrate.

6. The method of claim 1, wherein the feed-forward parameter of interest error data comprises data related to a substrate shape error, a substrate alignment error or an overlay error associated with the substrate.

7. The method of claim 1, wherein the feed-back parameter of interest error data comprises data related to a substrate shape error, a substrate alignment error or an overlay error associated with the previously processed substrate.

8. The method of claim 1, wherein the previously processed substrate has been processed according to a process step, wherein the expected deformation of the substrate is associated with said process step.

9. The method of claim 8, further comprising:
obtaining first feed-forward parameter of interest error data;
performing the process step on the substrate;
obtaining second feed-forward parameter of interest error data; and
obtaining the model based on the first feed-forward parameter of interest error data and the second feed-forward parameter of interest error data.

10. The method of claim 9, wherein the process step comprises any of etching, substrate bonding or polishing.

11. The method of claim 1, further comprising applying the determined backside process correction to the substrate.

12. A computer program comprising program instructions operable to perform the method as claimed in any of claims 1 to 6 when run on a suitable apparatus.

13. A non-transient computer program carrier comprising the computer program of claim 12.

14. A substrate manufactured according to the method of claim 1.

15. The substrate of claim 14, wherein the substrate is a bonded substrate.
